# EUROPÄISCHE PATENTSCHRIFT

(11) **EP 3 394 325 B1**
(45) Veröffentlichungstag und Bekanntmachung des Hinweises auf die Patenterteilung: **24.06.2020**
(21) Anmeldenummer: 16810302.6
(22) Anmeldetag: 07.12.2016
(51) Int. Cl.: C30B 29/06, C30B 15/30

(54) **SILICIUMSCHEIBE MIT HOMOGENER RADIALER SAUERSTOFFVARIATION**
SILICON WAFER HAVING A HOMOGENEOUS RADIAL OXYGEN VARIATION
TRANCHE DE SILICIUM À VARIATION RADIALE HOMOGÈNE DE L'OXYGÈNE

(30) Priorität: 22.12.2015 DE 102015226399
(43) Veröffentlichungstag der Anmeldung: 31.10.2018
(73) Patentinhaber: Siltronic AG, 81737 München (DE)
(72) Erfinder: MANGELBERGER, Karl, 5122 Ach (AT); HEUWIESER, Walter, 84533 Stammham (DE); SKROBANEK, Michael, 09599 Freiberg (DE)
(74) Vertreter: Killinger, Andreas
(86) Internationale Anmeldenummer: PCT/EP2016/080080
(87) Internationale Veröffentlichungsnummer: WO 2017/108406

(56) Entgegenhaltungen:
- DE-A1- 10 339 792
- DE-A1-102012 214 085
- JP-A- H07 291 783
- US-A1- 2010 101 485
- US-B1- 6 458 204
- Golla Eranna: "CRYSTSAL GROWTH AND EVALUATION OF SILICON for VLSI and ULSI" In: "CRYSTSAL GROWTH AND EVALUATION OF SILICON for VLSI and ULSI", 1. Januar 2015 (2015-01-01), CRC Press, Taylor & Francis Group, Boca Raton, FLorida USA, XP055348808, ISBN: 978-1-4822-3282-0 Seiten 13-16, das ganze Dokument

## Beschreibung

Gegenstand der Erfindung ist eine Siliciumscheibe mit homogener radialer Sauerstoffvariation.

Auf Grund ihrer Eigenschaften eignet sich die Siliciumscheibe insbesondere als Substratscheibe, auf deren oberer Seitenfläche (Vorderseite) eine epitaktische Schicht abgeschieden wird. Eine Siliciumscheibe mit abgeschiedener epitaktischer Schicht wird auch epitaktische Siliciumscheibe genannt.

Der Bereich der Siliciumscheibe, in dem die elektronischen Bauelemente untergebracht werden, muss vor Verunreinigung durch Metallspuren geschützt werden. Bei epitaktischen Siliciumscheiben befindet sich dieser Bereich üblicherweise in der epitaktischen Schicht. Einen besonders wirksamen Schutz vor metallischen Verunreinigungen bilden BMDs (bulk micro defects), Präzipitate von Sauerstoff in der Substratscheibe, weil sie so genannte interne Getter darstellen, an die sich metallische Verunreinigungen bevorzugt anlagern. BMDs wachsen aus Keimen heran, üblicherweise im Verlauf einer oder mehrerer Wärmebehandlungen, die zur Herstellung elektronischer Bauelemente notwendig sind. Es ist daher erforderlich, dass eine epitaktische Siliciumscheibe bei Auslieferung an den Hersteller elektronischer Bauelemente über genügend BMD-Keime in der Substratscheibe verfügt, damit eine hohe Dichte an BMDs entstehen kann.

Das Abscheiden der epitaktischen Schicht auf der Substratscheibe findet bei Temperaturen von über 1000 °C statt. Bei solchen Temperaturen werden kleinere BMD-Keime aufgelöst, was die Bereitstellung einer ausreichenden Anzahl von BMD-Keimen in hochdotierten Substratscheiben zusätzlich erschwert.

Wird der Einkristall, von dem die Siliciumscheibe stammt, gemäß der Czochralski-Methode (CZ-Methode) aus einer Schmelze gezogen, die in einem Quarztiegel gehalten wird, bildet das Tiegelmaterial die Quelle für Sauerstoff, der in den Einkristall und die daraus gewonnene Siliciumscheibe eingebaut wird.

Besondere Bedeutung beim Ziehen eines Einkristalls aus Silizium gemäß der CZ-Methode hat auch die Kontrolle des Verhältnisses V/G von Ziehgeschwindigkeit V und axialem Temperaturgradienten G an der Kristallisationsgrenze.

Die Ziehgeschwindigkeit V ist die Geschwindigkeit, mit der der wachsende Einkristall von der Schmelze weg nach oben gehoben wird, und der axiale Temperaturgradient G ist ein Maß, das die Änderung der Temperatur an der Kristallisationsgrenze in Richtung des Kristallhubs anzeigt.

BMDs lassen sich besonders in einem Gebiet entwickeln, in dem die Anzahl an Leerstellen diejenige an Silizium-Zwischengitteratomen übersteigt und in dem deshalb Leerstellen dominieren.

Zu den Eigenpunktdefekten gehören Zwischengitteratome aus Silicium (silicon self-interstitials) und Leerstellen (vacancies), die sich an der Wachstumsfront des Einkristalls bilden. Sie bestimmen ganz wesentlich die später im Einkristall auftretenden radialen und axialen Defektverteilungen und beeinflussen auch die auftretenden Fremdstoffverteilungen. Beispielsweise tragen Leerstellen zur Präzipitation von Sauerstoff bei.

Liegt das Verhältnis V/G über einem kritischen Wert k1, so treten überwiegend Leerstellendefekte (vacancies) auf, die agglomerieren können und dann beispielsweise als COPs (crystal originated particles) identifiziert werden können. Sie werden je nach Nachweismethode gelegentlich auch als LPD (light point defects) oder LLS (localized light scatterer) bezeichnet.

Liegt das Verhältnis von V/G unter einem kritischen Wert k2, der kleiner als k1 ist, so treten überwiegend Eigenpunktdefekte in Form von Zwischengitteratomen (silicon self-interstitials) in Erscheinung, die ebenfalls Agglomerate bilden können und sich makroskopisch als Versetzungsschleifen zeigen. Agglomerate von Zwischengitteratomen formen lokale Kristallversetzungen aus, die aufgrund der angewendeten Nachweismethode auch als LPITs (large etch pits) bezeichnet werden. Im weitesten Sinne wird der Bereich in dem weder eine Agglomeration von Leerstellen noch von Zwischengitteratomen stattfindet, in dem also V/G zwischen k1 und k2 liegt, als neutrale Zone oder perfekter Bereich bezeichnet. Der Wert von V/G bei dem der Kristall vom Leerstellen- zum Zwischengitterüberschuss wechselt liegt naturgemäß zwischen k1 und k2.

Man unterscheidet im engeren Sinne jedoch weiter einen Bereich, in dem sich noch freie, nicht agglomerierte Leerstellen befinden und ein von freien Zwischengitteratomen bestimmtes Gebiet. Der Leerstellenbereich, auch v-Gebiet (vacancies) genannt, zeichnet sich dadurch aus, dass bei genügend hohem Sauerstoffgehalt des Einkristalls dort oxidationsinduzierte Stapelfehler entstehen, während der i-Bereich (interstitials) völlig fehlerfrei bleibt. In diesem engeren Sinne ist daher nur das i-Gebiet ein wirklich perfekter Kristallbereich.

Leerstellen tragen zur Präzipitation von Sauerstoff bei. Sauerstoffpräzipitate bilden, wenn sie eine Größe von etwa 70 nm überschreiten, sauerstoffinduzierte Stapelfehler (OSF). Daher findet man OSF vor allem im v-Bereich.

Der axiale Temperaturgradient G an der Kristallisationsgrenze und dessen radialer Verlauf werden bestimmt durch den Wärmetransport von und zur Kristallisationsgrenze. Der Wärmetransport wird wiederum wesentlich beeinflusst durch die thermischen Eigenschaften der Umgebung des wachsenden Einkristalls, der sogenannten hot zone, und durch die Wärmezufuhr durch eine oder mehrere Heizvorrichtungen.

Ist die Entscheidung gefallen, einen Einkristall in einer bestimmten hot zone zu ziehen, kann der axiale und radiale Verlauf des axialen Temperaturgradient G an der Kristallisationsgrenze mittels Simulationsrechnungen, die die Wärmebilanz berücksichtigen, bestimmt werden.

Um den Quotienten V/G auch in axialer Richtung in einem vorgesehenen Bereich zu halten, ist es erforderlich, die zeitliche Änderung des axialen Temperaturgradienten G durch eine entsprechende Änderung der Ziehgeschwindigkeit V zu kompensieren. Durch das Kontrollieren der Ziehgeschwindigkeit V kann also auch der Quotient V/G kontrolliert werden.

WO 98/45508 A1 ist eine von zahlreichen Veröffentlichungen, die beschreibt, wie der zeitliche Verlauf der Ziehgeschwindigkeit V experimentell ermittelt werden kann, um über die Kontrolle der Ziehgeschwindigkeit V zu erreichen, dass der Quotient V/G während des Wachstums des Einkristalls nahezu unverändert bleibt und der Einkristall in einem vorgesehenen Gebiet wachsen kann. Darüber hinaus sind Nachweismethoden zur Charakterisierung und Unterscheidung von Pv-Gebiet und Pi-Gebiet beschrieben.

Golla Eranna: "Crystal growth and evaluation of silicon for VLSI and ULSI", 1. Januar 2015, CRC Press, Taylor & Francis Group, Boca Raton, Florida USA, XP055348808, ISBN: 978-1-4822-3282-0, Seiten 13-16 offenbart Siliciumscheiben mit einem Durchmesser von 300 mm, abgetrennt von einem mittels des CZ-Verfahrens gewachsenen Einkristall, mit einer radialen Variation der Sauerstoffkonzentration von weniger als 10'%, Für Siliciumscheiben mit einem Durchmesser von 150 mm oder 200 mm beträgt die radiale Variation der Sauerstoffkonzentration weniger als 5%.

DE 103 39 792 A1 offenbart Einkristalle aus Silicium, welche durch Ziehen des Einkristalls gemäß der Czochralski-Methode hergestellt werden.

US 5968264 A offenbart ein Verfahren zum Herstellen eines Siliciumeinkristalls gemäß einem Czochralski-Verfahren, dadurch gekennzeichnet, dass während des Wachstums des Siliciumeinkristalls aus einer Siliziumschmelze das Ziehen so durchgeführt wird, so dass eine Fest-Flüssig-Grenzfläche im Kristall besteht in einem Bereich einer durchschnittlichen vertikalen Position der Fest-Flüssig-Grenzfläche von +/- 5 mm, wobei ein Randbereich einer Breite von 5 mm ausgenommen ist.

In einer Ausführungsform wird der Kristall im v- oder i-Gebiet gezogen.

Es wird offenbart, ein horizontales Magnetfeld einer Intensität von nicht weniger als 2000 Gs (Gauss) an die Siliciumschmelze anzulegen. Das Anlegen eines Magnetfelds an die Schmelze führt zu einem kleineren Temperaturgradienten G und zu einer Abflachung der Fest-Flüssig-Grenzfläche. Das v- oder i-Gebiet dehnt sich aus. Zudem lässt sich mit Magnetfeldern der axiale Verlauf der Sauerstoffkonzentrationen steuern.

US 6159438 A, das auf dieselbe Prioritätsanmeldung wie US 5968264 A zurück geht, beansprucht einen Siliciumeinkristall, der mittels eines Czochralski-Verfahrens gezüchtet wird, dadurch gekennzeichnet, dass die Variation der Sauerstoffkonzentration in einer Richtung, die senkrecht zu einer Wachstumsrichtung liegt, nicht höher als 5 % ist.

Die Sauerstoffkonzentrationen wurden in Wachstumsrichtung an einem aufgeschnittenen Kristall bestimmt, wobei Messungen im Zentrum des Kristalls und in einem Randbereich mit einem Abstand von 10 mm zur Kante erfolgten. Beispiel und Vergleichsbeispiel, vgl. Fig. 11A und 11B, unterscheiden sich jedoch nur dadurch voneinander, dass im Vergleichsbeispiel ein im Beispiel vorhandener Fest-Flüssig-Grenzflächen- Wärmeisolierstoff und ein darauf angeordneter ringförmiger Wärmeisolierstoff entfernt wurden. Der Effekt bzgl. der Homogenisierung von axialen Sauerstoffvariationen im Zentrum des Kristalls und in einem Randbereich mit einem Abstand von 10 mm zur Kante ist also ausschließlich auf das Vorhandensein dieser Wärmeisolierstoffe zurückzuführen.

Allerdings zeigt sich, dass die Sauerstoffkonzentration gerade im dabei nicht betrachteten Randbereich (Abstand 10 mm zur Kante) deutlich abfällt. Dies zeigt sich sowohl bei Kristallen mit einem Durchmesser von 200 mm wie nach US 6159438 A als auch bei Siliciumkristallen mit einem Durchmesser von 300 mm in einem Bereich eines Abstandes von 140-150 mm vom Zentrum.

Dieser Abfall der Sauerstoffkonzentration am Rand hat negativen Einfluss auf die mechanische Stabilität der Siliciumscheiben. Zum anderen führt dies bei epitaktischen Siliciumscheiben zu einer zu geringen BMD-Dichte im Randbereich. Dies kann Gitterdefekte und Overlay-Probleme bei Kunden zur Folge haben. Ursache für die Entstehung von Overlay-Defekten sind Spannungen im Kristallgitter auf Grund einer zu geringen Dichte von BMDs, weil in einem solchen Fall die Wirkung von BMDs, Gleitungen im Kristallgitter zu blockieren, das sogenannte Pinning, zu schwach ausgeprägt ist.

Aus dieser Problematik ergab sich die Aufgabenstellung der Erfindung.

Die Aufgabe der Erfindung wird gelöst durch eine Siliciumscheibe mit einem Durchmesser von 300 mm, abgetrennt von einem mittels des CZ-Verfahrens gewachsenen Einkristall, mit einer Sauerstoffkonzentration von 5 x 10¹⁷ Atome/cm³ bis 6 x 10¹⁷ Atome/cm³ und mit einer radialen Variation der Sauerstoffkonzentration von weniger als 7%, ermittelt gemäß (Omax - Omin / Omin) * 100%, wobei Omax die maximale und Oₘᵢₙ die minimale über den gesamten Radius der Siliciumscheibe ermittelte Sauerstoffkonzentration bezeichnen, wobei die Sauerstoffkonzentration mittels FTIR nach SEMI MF951 ermittelt wird, wobei die Siliciumscheibe mit Wasserstoff dotiert ist und eine Wasserstoff-Konzentration nicht weniger als 3 x 10¹³ Atome/cm³ und nicht mehr als 8 x 10¹³ Atome/cm³ beträgt.

Die Messung der Sauerstoffkonzentration erfolgt mittels FTIR nach SEMI MF951. Dazu eignet sich beispielsweise das Bruker Equinox55s Spektrometer. Mit diesem Gerät können SEMI Standardscheiben mit Durchmessern 100, 125, 150, 200 und 300 mm vermessen werden. Es eignet sich jedoch auch zur Untersuchung von Stabstücken.

Um die Sauerstoffkonzentration im Randbereich zu bestimmen, ist es von Vorteil, Stabstücke und nicht Standardscheiben zu untersuchen. Damit ist es auch möglich, die Sauerstoffkonzentration im Randbereich von Kristallen mit einem Durchmesser von 450 mm zu untersuchen.

Die Siliciumscheibe zeigt eine radiale Variation der Sauerstoffkonzentration von weniger als 7%, wobei der gesamte Radius der Siliciumscheibe berücksichtigt ist.

In einer Ausführungsform beträgt die radiale Variation der Sauerstoffkonzentration der Siliciumscheibe weniger als 5%.

Vorzugweise beträgt die radiale Variation der Sauerstoffkonzentration der Siliciumscheibe weniger als 2%.

In einer Ausführungsform ist die Siliciumscheibe epitaktisch beschichtet.

In einer Ausführungsform wird die Siliciumscheibe vor der epitaktischen Beschichtung thermisch behandelt, um BMD-Keime zu stabilisieren.

In einer weiteren Ausführungsform ist die Siliciumscheibe mit Stickstoff dotiert und weist eine Stickstoff-Konzentration von nicht weniger als 5 x 10¹² Atome/cm³ und nicht mehr als 3,5 x 10¹³ Atome/cm³ auf.

In einer Ausführungsform ist die Siliciumscheibe mit Bor dotiert. Die Bor-Konzentration liegt in einem Bereich von 3,10 x 10¹⁸ Atome/cm³ bis 8,43 x 10¹⁸ Atome/cm³.

In einer anderen Ausführungsform ist die Siliciumscheibe mit Stickstoff und Wasserstoff dotiert. Eine Stickstoff-Konzentration beträgt nicht weniger als 5 x 10¹² Atome/cm³ und nicht mehr als 3,5 x 10¹³ Atome/cm³. Eine Wasserstoff-Konzentration beträgt nicht weniger als 3 x 10¹³ Atome/cm³ und nicht mehr als 8 x 10¹³ Atome/cm³.

In einer Ausführungsform ist die Siliciumscheibe mit einer epitaktischen Schicht versehen, wobei die epitaktische Siliciumscheibe p/p+ dotiert ist und BMD-Keime umfasst, deren über den Radius der Siliciumscheibe gemittelte Dichte, bestimmt durch IR-Tomographie, nicht weniger als 1 x 10⁵ cm⁻³ und nicht mehr als 1 x 10⁷ cm⁻³ beträgt. Darüber hinaus ist die Variation der Dichte an BMD-Keimen entlang des Radius der epitaktischen Siliciumscheibe gering. Die Dichte an BMD-Keimen schwankt vom Zentrum bis zum Rand der epitaktischen Siliciumscheibe um nicht mehr als 20 % vom Mittelwert.

In einer Ausführungsform ist die Siliciumscheibe mit einer epitaktischen Schicht versehen, wobei die epitaktische Siliciumscheibe p/p- dotiert ist und nach einer Wärmebehandlung bei einer Temperatur von 1000 °C über einen Zeitraum von 16 h eine BMD-Dichte im Bereich der Siliciumsubstratscheibe vom Zentrum bis zum Rand der epitaktischen Siliciumscheibe von nicht weniger als 1 x 10⁸ cm⁻³, vorzugsweise nicht weniger als 5 x 10⁸ cm⁻³ aufweist. Darüber hinaus ist die Variation der BMD-Dichte entlang des Radius der epitaktischen Siliciumscheibe gering. Die BMD-Dichte schwankt vom Zentrum bis zum Rand der epitaktischen Siliciumscheibe um nicht mehr als 20 % vom Mittelwert.

Eine Siliciumscheibe lässt sich herstellen durch ein Verfahren, umfassend
a) Bereitstellen einer Schmelze aus Silicium in einem Tiegel;
b) Ziehen eines Einkristalls aus Silicium aus der Schmelze gemäß der CZ-Methode, wobei Sauerstoff in den Einkristall eingebaut wird;
c) Anlegen eines horizontalen Magnetfelds an die Schmelze während des Ziehens des Einkristalls aus Silicium;
d) Drehung von wachsendem Kristall und Tiegel während des Ziehens des Einkristalls;
e) Bereitstellen der Siliciumscheibe durch Bearbeiten des Einkristalls aus Silicium; dadurch gekennzeichnet, dass eine magnetische Flussdichte des angelegten horizontalen Magnetfelds in der Tiegelmitte 0,19-0,26 T (1900-2600 Gs) beträgt und dass der wachsende Kristall mit mindestens 8 U/min gedreht wird.

In einer Ausführungsform beträgt die magnetische Flussdichte 0,2-0,24 T (2000-2400 Gs).

In einer anderen Ausführungsform beträgt die magnetische Flussdichte 0,215-0,235 T (2150-2350 Gs).

Vorzugweise werden Kristall und Tiegel gleichsinnig gedreht.

In einer weiteren Ausführungsform wird der Tiegel mit 0,3-0,8 U/min gedreht.

In einer besonders bevorzugten Ausführungsform wird der wachsende Kristall mit mindestens 10 U/min gedreht.

Das Bereitstellen der Siliciumscheibe umfasst ein Zerschneiden des Kristalls in Scheiben und nachfolgend verschiedene mechanische und chemo-mechanische Bearbeitungen von Seitenflächen und Kante der Siliciumscheibe.

In einer Ausführungsform wird die Siliciumscheibe auf einer polierten Seitenfläche mit einer epitaktischen Schicht versehen.

Es hat sich gezeigt, dass eine homogene radiale Sauerstoffverteilung der Siliciumscheibe auch unter Berücksichtigung des kompletten Randbereiches der Siliciumscheibe nur zu bewerkstelligen ist, wenn sowohl die magnetische Flussdichte im oben angegebenen Bereich liegt als auch für die Kristalldrehung eine bestimmte Mindestgeschwindigkeit eingehalten wird.

Beim Anlegen von höheren magnetische Flussdichten wie z.B. 0,27 T (2700 Gs) zeigt sich ein starker Abfall der Sauerstoffkonzentration am Rand, bei 300 mm-Scheiben beispielsweise in einem Bereich eines Abstands von 140-150 mm vom Zentrum der Scheibe. Dies führt dazu, dass die radiale Variation der Sauerstoffkonzentration über den gesamten Radius der Scheibe mehr als 10% betragen kann.

Ebenso zeigt sich ein solcher Abfall der Sauerstoffkonzentration am Rand, wenn die Drehgeschwindigkeit des Kristalls weniger als 8 U/min beträgt. Die an sich bekannte Drehung von Kristall und Tiegel erfolgt über eine geeignete Antriebseinheit.

Besonders vorteilhaft ist, dass trotz der Reduzierung des Magnetfeldes Kristalle ohne L-Pits und COPs gezogen werden können. Bislang wurde davon ausgegangen, dass hohe magnetische Flussdichten (z.B. 0,3 T bzw. 3000 Gs) zur Homogenisierung von v/G erforderlich sind.

Durch die Reduzierung des Randabfalls der Sauerstoffkonzentration kann die BMD-Dichte am Rand einer epitaxierten Siliciumscheibe oder bei einer Siliciumscheibe, die einer Temperaturbehandlung unterzogen wurde, hoch gehalten werden.

In einer Ausführungsform wird eine epitaktische Siliciumscheibe, die p/p+ dotiert ist hergestellt. Dazu werden beim Ziehen des Einkristalls Sauerstoff und Bor in den Einkristall eingebaut, wobei die Konzentration von Sauerstoff im Einkristall nicht weniger als 5 x 10¹⁷ Atome/cm³ und nicht mehr als 6 x 10¹⁷ Atome/cm³ beträgt und die Resistivität des Einkristalls nicht weniger als 5 mΩcm und nicht mehr als 10 mΩcm ist.

Eine Wärmebehandlung der Siliciumsubstratscheibe vor der Epitaxie zum Zweck der Stabilisierung von BMD-Keimen ist nicht erforderlich, wenn der Einkristall unter Bedingungen gezogen und abgekühlt wird, die die Entstehung von BMD-Keimen und deren Stabilisierung unterstützen.

Insbesondere sollte der Einkristall im Temperaturbereich von 1000 °C bis 800 °C vergleichsweise langsam abgekühlt werden, wobei die Abkühlrate in diesem Temperaturbereich nicht weniger als 0,5 °C/min und nicht mehr als 1,2 °C/min beträgt.

Der Einkristall wird unter Bedingungen gezogen, unter denen eine vergleichsweise niedrige Konzentration an Sauerstoff und eine vergleichsweise hohe Konzentration an Bor in den Einkristall eingebaut wird. Zum Einstellen der Bor-Konzentration im Einkristall wird die Schmelze mit Bor dotiert.

Zudem wird der Einkristall unter Bedingungen gezogen, die einkristallines Silizium entstehen lässt, in dem Vakanzen gegenüber interstitiellen Siliciumatomen als Punktdefekte dominieren (v-Gebiet).

Der gezogene Einkristall wird zu Substratscheiben aus einkristallinem Silizium verarbeitet. Die Substratscheibe weist nach den Verarbeitungsschritten eine polierte Kante und mindestens eine polierte Seitenfläche auf. Vorzugsweise werden beide Seitenflächen, also die Vorderseite und die Rückseite poliert.

Auf der polierten Seitenfläche der Substratscheibe beziehungsweise der polierten Vorderseite wird eine epitaktische Schicht aus Silicium abgeschieden. Die entstehende epitaktische Siliciumscheibe hat eine hohe Anzahl an BMD-Keimen auch im Randbereich, die sich zu BMDs entwickeln lassen.

Nach Standard-Tests wie einer Wärmebehandlung bei einer Temperatur von 1000 °C über einen Zeitraum von 16 h oder einer ersten Wärmebehandlung bei einer Temperatur von 780 °C über einen Zeitraum von 3 h gefolgt von einer zweiten Wärmebehandlung bei einer Temperatur von 1000 °C über einen Zeitraum von 16 h beträgt die BMD-Dichte im Bereich der Substratscheibe der epitaktischen Siliciumscheibe vom Zentrum bis zum Rand der epitaktischen Siliciumscheibe nicht weniger als 1 x 10⁸ cm⁻³, vorzugsweise nicht weniger als 5 x 10⁸ cm⁻³. Darüber hinaus ist die Variation der BMD-Dichte entlang des Radius der epitaktischen Siliciumscheibe gering. Die BMD-Dichte schwankt vom Zentrum bis zum Rand der epitaktischen Siliciumscheibe um nicht mehr als 20 % vom Mittelwert.

In einer weiteren Ausführungsform wird die Schmelze mit Sauerstoff, Stickstoff und Wasserstoff dotiert. Die Sauerstoff-Konzentration beträgt nicht weniger als 4,9 x 1017 Atome/cm3 und nicht mehr als 5,7 x 10¹⁷ Atome/cm³, die Stickstoff-Konzentration nicht weniger als 5 x 10¹² Atome/cm³ und nicht mehr als 3,5 x 10¹³ Atome/cm³ und die Wasserstoff-Konzentration nicht weniger als 3 x 10¹³ Atome/cm³ und nicht mehr als 8 x 10¹³ Atome/cm³.

Zudem wird der Einkristall unter Bedingungen gezogen, die einkristallines Silizium entstehen lässt, in dem Vakanzen gegenüber interstitiellem Siliciumatomen als Punktdefekte dominieren (v-Gebiet).

Die Gegenwart von Wasserstoff unterdrückt die Bildung von Keimen von OSF-Defekten und trägt zu einer Vergleichmäßigung des radialen Verlaufs der Dichte von BMDs bei, insbesondere im Randbereich der Siliciumscheibe. Die Wasserstoff-Konzentration in der Siliciumscheibe sollte deshalb nicht weniger als 3 x 10¹³ Atome/cm³ betragen. Der Einkristall wird in einer Atmosphäre gezogen, die Wasserstoff enthält, wobei der Partialdruck des Wasserstoffs vorzugsweise nicht weniger als 5 Pa und nicht mehr als 15 Pa beträgt.

Vom gewachsenen Kristall wird eine Siliciumscheibe abgetrennt und weiterverarbeitet. Dabei werden die obere und die untere Seitenfläche sowie die Kante der Siliciumscheibe einem oder mehreren mechanischen Bearbeitungsschritten und mindestens einer Politur unterzogen. Auf der polierten oberen Seitenfläche der Siliciumscheibe wird vorzugsweise eine epitaktische Schicht abgeschieden. Die Siliciumscheibe und die epitaktische Schicht sind mit einem elektrisch aktiven Dotierstoff wie beispielsweise Bor dotiert, vorzugsweise entsprechend der Dotierung einer pp-- dotierten epitaktischen Siliciumscheibe.

Die entlang des Radius der Siliciumscheibe gemittelte Dichte von BMD-Keimen, bestimmt durch IR-Tomographie, beträgt nicht weniger als 1 x 10⁵ cm⁻³ und nicht mehr als 1 x 10⁷ cm⁻³. Die Dichte an BMD-Keimen schwankt vom Zentrum bis zum Rand der epitaktischen Siliciumscheibe um nicht mehr als 20 % vom Mittelwert.

Die durch das Abscheiden einer epitaktischen Schicht auf der Vorderseite der Siliciumscheibe entstehende Siliciumscheibe mit epitaktischer Schicht hat trotz des Abscheidens der epitaktischen Schicht das Potenzial, BMDs bilden zu können, deren Dichte ausreicht, um der Siliciumscheibe die erforderliche Wirkung als interner Getter zu verleihen. Die Dichte von BMDs bleibt jedoch ausreichend niedrig und deren radialer Verlauf ausreichend homogen, so dass Probleme wegen Overlay-Defekten vermieden werden.

Die BMDs werden vorzugsweise im Zuge der Herstellung elektronischer Bauelemente in der epitaktischen Schicht und damit einhergehender Wärmebehandlungen gebildet. Sie können aber auch gebildet werden, indem die Siliciumscheibe nach dem Abscheiden der epitaktischen Schicht und vor der Herstellung elektronischer Bauelemente einer oder mehrerer Wärmebehandlungen unterzogen wird.

Die bezüglich der vorstehend aufgeführten Ausführungsformen der erfindungsgemäßen Siliciumscheibe bzw. der erfindungsgemäßen epitaktischen Siliciumscheiben angegebenen Merkmale werden in der Figurenbeschreibung und in den Ansprüchen erläutert.

In den nachfolgenden Beispielen wurden in Einklang mit dem erfindungsgemäßen Verfahren Kristalle mit einem Durchmesser von etwa 300 mm gewachsen. An diesen Kristallen bzw. den daraus erzeugten Stabstücken oder Siliciumscheiben wurde die radiale Sauerstoffvariation bestimmt.

### Kurzbeschreibung der Figuren

**Fig. 1** zeigt radiale Sauerstoffverläufe bei unterschiedlichen magnetischen Flussdichten.
**Fig. 2** zeigt radiale Sauerstoffverläufe bei unterschiedlichen magnetischen Flussdichten.
**Fig. 3** zeigt radiale Sauerstoffverläufe bei unterschiedlichen magnetischen Flussdichten.
**Fig. 4** zeigt radiale Sauerstoffverläufe bei unterschiedlichen Kristalldrehungen.

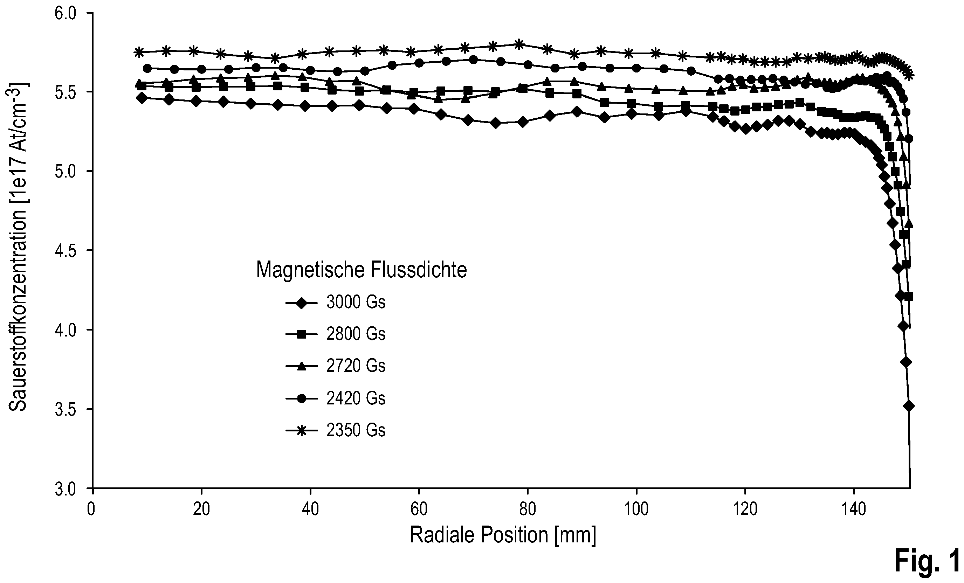

**Fig. 1** zeigt die mittels FTIR bestimmten radialen Sauerstoffverläufe bei unterschiedlichen magnetischen Flussdichten (0,3 T (3000 Gs), 0,28 T (2800 Gs), 0,272 T (2720 Gs), 0,242 T (2420 Gs), 0,235 T (2350 Gs))

Die Kristallrotation beträgt 10 U/min. Die Tiegelrotation beträgt 0,3 U/min. Kristall und Tiegel werden gleichsinnig gedreht.

Je kleiner die magnetische Flussdichte, desto kleiner der Randabfall.

Bei einer magnetischen Flussdichte von 0,235 T (2350 Gs) ergibt sich eine radiale Sauerstoffvariation von 2,3 %.

Bei weiteren Messungen hat sich gezeigt, dass bei einer magnetischen Flussdichte von 0,215-0,235 T (2150-2350 Gs) die radiale Sauerstoffvariation vielfach sogar weniger als 2% beträgt.

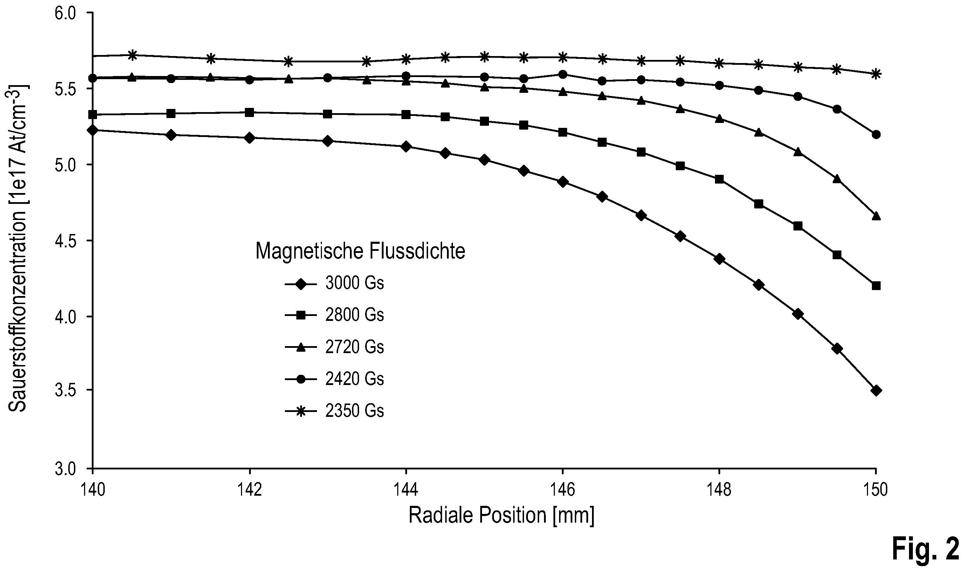

**Fig. 2** zeigt die radialen Sauerstoffverläufe von **Fig.1** im Randbereich (R=140-150 mm).

Ab einer radialen Position von etwa 144 mm zeigt sich bei magnetischen Flussdichten von größer als 0,27 T (2700 Gs) ein deutlicher Abfall der Sauerstoffkonzentration.

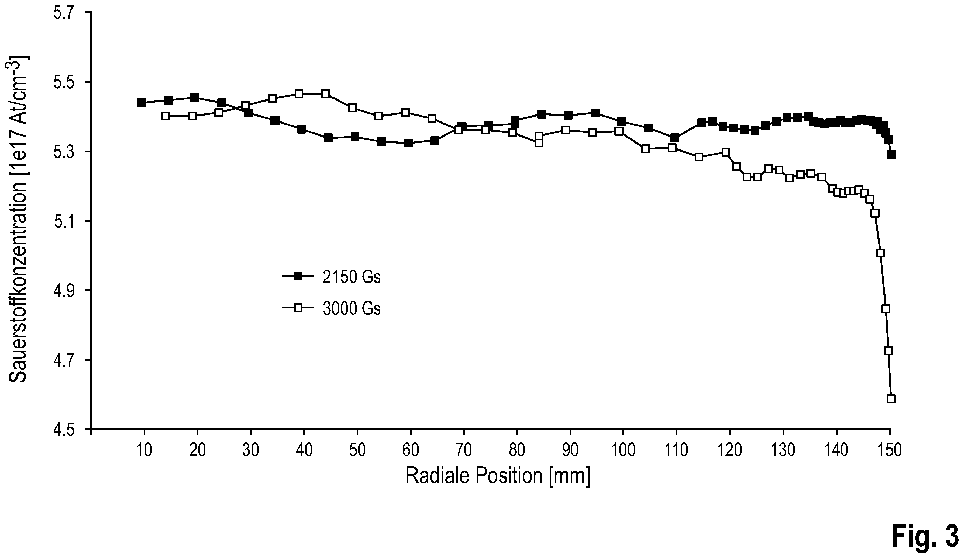

**Fig. 3** zeigt die mittels FTIR bestimmten radialen Sauerstoffverläufe bei den magnetischen Flussdichten 0,215 T (2150 Gs) und 0,3 T (3000 Gs). Die Kristallrotation beträgt 10 U/min. Die Tiegelrotation beträgt 0,3 U/min. Kristall und Tiegel werden gleichsinnig gedreht.

Für die radiale Sauerstoffvariation ergibt sich, sofern der gesamte Radius berücksichtigt wird, 3,1% bei 0,215 T (2150 Gs) und 19,2% bei 0,3 T (3000 Gs).

Wird allerdings ein Randbereich von 10 mm nicht berücksichtigt, die radiale Sauerstoffvariation also nur von R=0 bis R=140mm bestimmt, ergibt sich 2,5% bei 0,215 T (2150 Gs) und 5,4% bei 0,3 T (3000 Gs).

Dies zeigt den deutlichen Abfall der Sauerstoffkonzentration am Rand (R = 140-150 mm) bei zu hohen Magnetfeldern.

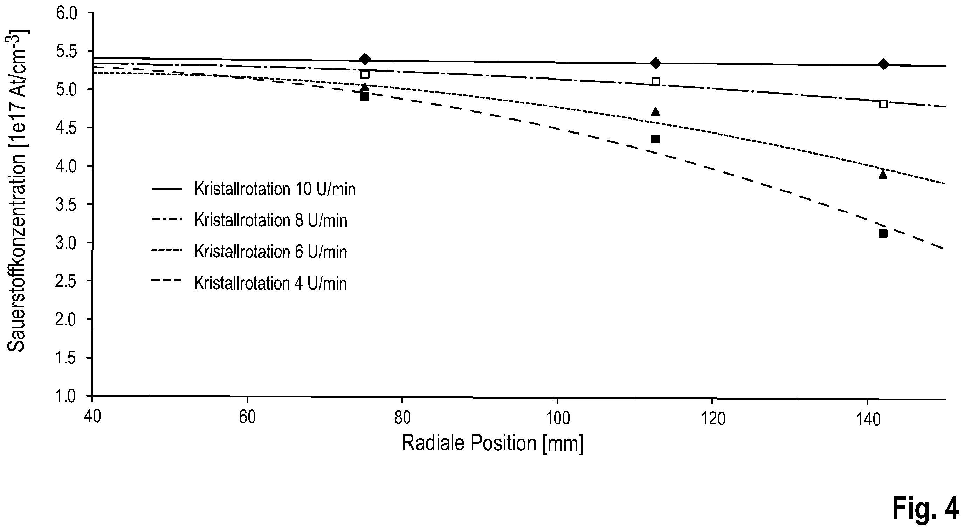

**Fig. 4** zeigt die mittels FTIR bestimmten radialen Sauerstoffverläufe bei unterschiedlichen Kristallrotationen. Die Tiegelrotation beträgt 0,3 U/min. Die Kristallrotation wird variiert: 4, 6, 8 und 10 U/min. Die magnetische Flussdichte beträgt 0,23 T (2300 Gs).

Es zeigt sich, dass die Sauerstoffkonzentration mit abnehmender Kristallrotation deutlich abfällt. Der Abfall setzt bereits bei einem radialen Abstand von etwa 80 mm ein.

Bei einer Kristallrotation von 10 U/min ergibt sich eine radiale Sauerstoffvariation von 1,5%.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen sowie Äquivalente durch den Schutzbereich der Ansprüche abgedeckt sein.

## Patentansprüche

1. Siliciumscheibe mit einem Durchmesser von 300 mm, abgetrennt von einem mittels des Czochralski (CZ)-Verfahrens gewachsenen Einkristall, mit einer Sauerstoffkonzentration von 5 x 10¹⁷ Atome/cm³ bis 6 x 10¹⁷ Atome/cm³ und mit einer radialen Variation der Sauerstoffkonzentration von weniger als 7%, ermittelt gemäß (Oₘₐₓ - Oₘᵢₙ / Oₘᵢₙ) ^{∗} 100%, wobei Omax die maximale und Omin die minimale über den gesamten Radius der Siliciumscheibe ermittelte Sauerstoffkonzentration bezeichnen, wobei die Sauerstoffkonzentration mittels FTIR nach SEMI MF951 ermittelt wird, wobei die Siliciumscheibe mit Wasserstoff dotiert ist und eine Wasserstoff-Konzentration nicht weniger als 3 x 10¹³ Atome/cm³ und nicht mehr als 8 x 10¹³ Atome/cm³ beträgt.

2. Siliciumscheibe nach Anspruch 1, wobei die radiale Variation der Sauerstoffkonzentration weniger als 5% beträgt.

3. Siliciumscheibe nach Anspruch 2, wobei die radiale Variation der Sauerstoffkonzentration weniger als 2% beträgt

4. Siliciumscheibe nach einem der Ansprüche 1 bis 3, wobei die Siliciumscheibe mit Stickstoff dotiert ist und eine Stickstoff-Konzentration von nicht weniger als 5 x 10¹² Atome/cm³ und nicht mehr als 3,5 x 10¹³ Atome/cm³ aufweist.

5. Epitaktische Siliciumscheibe, die p/p+ dotiert ist, umfassend als Substrat eine Siliciumscheibe nach einem der Ansprüche 1 bis 4, wobei sie BMD (bulk micro defects)-Keime umfasst, deren über den Radius der Siliciumscheibe gemittelte Dichte, bestimmt durch IR-Tomographie, nicht weniger als 1 x 10⁵ cm⁻³ und nicht mehr als 1 x 10⁷ cm⁻³ beträgt, wobei eine Dichte an BMD-Keimen vom Zentrum bis zum Rand der epitaktischen Siliciumscheibe um nicht mehr als 20 % vom Mittelwert abweicht.

6. Epitaktische Siliciumscheibe nach Anspruch 5, wobei eine Resistivität nicht weniger als 5 mΩcm und nicht mehr als 10 mΩcm beträgt.

7. Epitaktische Siliciumscheibe, die p/p- dotiert ist, umfassend als Substrat eine Siliciumscheibe nach einem der Ansprüche 1 bis 4, wobei sie nach einer Wärmebehandlung bei einer Temperatur von 1000 °C über einen Zeitraum von 16 h eine BMD-Dichte, bestimmt durch IR-Tomographie, im Bereich der Siliciumsubstratscheibe vom Zentrum bis zum Rand der epitaktischen Siliciumscheibe von nicht weniger als 1 x 10⁸ cm⁻³ aufweist, wobei eine Dichte an BMD-Keimen, bestimmt durch IR-Tomographie, vom Zentrum bis zum Rand der epitaktischen Siliciumscheibe um nicht mehr als 20 % vom Mittelwert abweicht.

## Claims

1. A silicon wafer with a diameter of 300 mm, separated from a single crystal grown by the Czochralski (CZ) method, with an oxygen concentration of 5 x ¹⁰¹⁷ atoms/cm3 to 6 x ¹⁰¹⁷ atoms/cm3 and with a radial variation of the oxygen concentration of less than 7%, determined according to (Omax - Omin / Omin) ^{∗} 100%, where Omax is the maximum and Omin is the minimum oxygen concentration determined over the entire radius of the silicon wafer, wherein the oxygen concentration is determined by FTIR according to SEMI MF951, wherein the silicon wafer is doped with hydrogen and a hydrogen concentration is not less than 3 x ¹⁰¹³ atoms/cm3 and not more than 8 x ¹⁰¹³ atoms/cm3.

2. The silicon wafer according to claim 1, wherein the radial variation of the oxygen concentration is less than 5%.

3. The silicon wafer according to claim 2, wherein the radial variation of the oxygen concentration is less than 2%.

4. A silicon wafer according to any one of claims 1 to 3, wherein said silicon wafer is doped with nitrogen and has a nitrogen concentration of not less than 5 x ¹⁰¹² atoms/cm3 and not more than 3.5 x ¹⁰¹³ atoms/cm3.

5. An epitaxial silicon wafer doped p/p+ comprising as a substrate a silicon wafer according to any one of claims 1 to 4, wherein it comprises bulk micro defect (BMD) nuclei whose density averaged over the radius of the silicon wafer as determined by IR tomography is not less than 1 x ¹⁰⁵ cm-3 and not more than 1 x ¹⁰⁷ cm-3, wherein a density of BMD nuclei from the center to the edge of the epitaxial silicon wafer differs from the average by not more than 20%.

6. The epitaxial silicon wafer according to claim 5, wherein a resistivity is not less than 5 mΩcm and not more than 10 mΩcm.

7. A p/p-doped epitaxial silicon wafer comprising as substrate a silicon wafer according to any one of claims 1 to 4, which after a heat treatment at a temperature of 1000°C for a period of 16 hours has a BMD densitydetermined by IR tomography, in the region of the silicon substrate wafer from the center to the edge of the epitaxial silicon wafer of not less than 1 x ¹⁰⁸ cm-3, wherein a density of BMD nuclei, as determined by IR tomography, from the center to the edge of the epitaxial silicon wafer differs from the average value by not more than 20%.

## Revendications

1. Une plaquette de silicium d'un diamètre de 300 mm, séparée d'un monocristal cultivé par la méthode de Czochralski (CZ), avec une concentration en oxygène de 5 x ¹⁰¹⁷ atomes/cm3 à 6 x ¹⁰¹⁷ atomes/cm3 et avec une variation radiale de la concentration en oxygène inférieure à 7%, déterminée selon (Omax - Omin / Omin) ^{∗} 100%, où Omax est le maximum et Omin est la concentration minimale d'oxygène déterminée sur tout le rayon de la plaquette de silicium, où la concentration d'oxygène est déterminée par FTIR selon SEMI MF951, où la plaquette de silicium est dopée avec de l'hydrogène et une concentration d'hydrogène n'est pas inférieure à 3 x ¹⁰¹³ atomes/cm3 et pas supérieure à 8 x ¹⁰¹³ atomes/cm3.

2. La plaquette de silicium selon la revendication 1, dans laquelle la variation radiale de la concentration en oxygène est inférieure à 5 %.

3. La plaquette de silicium selon la revendication 2, dans laquelle la variation radiale de la concentration en oxygène est inférieure à 2%.

4. Plaquette de silicium selon l'une quelconque des revendications 1 à 3, dans laquelle ladite plaquette de silicium est dopée à l'azote et a une concentration en azote non inférieure à 5 x ¹⁰¹² atomes/cm3 et non supérieure à 3,5 x ¹⁰¹³ atomes/cm3.

5. Plaquette de silicium épitaxiale dopée p/p+ comprenant comme substrat une plaquette de silicium selon l'une quelconque des revendications 1 à 4, **caractérisée en ce qu'**elle comprend des noyaux de micro-défauts (BMD) en vrac dont la densité moyenne sur le rayon de la plaquette de silicium, telle que déterminée par tomographie IR, n'est pas inférieure à 1 x ¹⁰⁵ cm-3 et pas supérieure à 1 x ¹⁰⁷ cm-3, dans laquelle une densité de noyaux de BMD du centre au bord de la plaquette de silicium épitaxiale ne diffère pas de la moyenne de plus de 20%.

6. La plaquette de silicium épitaxiale selon la revendication 5, dans laquelle une résistivité n'est pas inférieure à 5 mΩcm et pas supérieure à 10 mΩcm.

7. Plaquette de silicium épitaxiale dopée p/p comprenant comme substrat une plaquette de silicium selon l'une quelconque des revendications 1 à 4, qui après un traitement thermique à une température de 1000°C pendant une période de 16 heures a une densité de DMOdéterminée par tomographie IR, dans la région de la plaquette de substrat de silicium, du centre au bord de la plaquette de silicium épitaxiale, d'au moins 1 x ¹⁰⁸ cm-3, dans laquelle une densité de noyaux de DMO, telle que déterminée par tomographie IR, du centre au bord de la plaquette de silicium épitaxiale, ne diffère pas de la valeur moyenne de plus de 20%.
